(19) Europäisches Patentamt / European Patent Office / Office européen des brevets

(11) **EP 3 466 758 B1**

(12) **EUROPEAN PATENT SPECIFICATION**

(45) Date of publication and mention
of the grant of the patent:
**29.09.2021 Bulletin 2021/39**

(51) Int Cl.:
**B60Q 1/38** *(2006.01)*   **B60Q 1/34** *(2006.01)*
**H05B 47/10** *(2020.01)*   **H03K 17/26** *(2006.01)*
**H03K 17/567** *(2006.01)*

(21) Application number: **17806345.9**

(22) Date of filing: **12.05.2017**

(86) International application number:
**PCT/JP2017/018024**

(87) International publication number:
**WO 2017/208787 (07.12.2017 Gazette 2017/49)**

(54) **LAMP CONTROL DEVICE AND LAMP LIGHTING SYSTEM**

LAMPENSTEUERUNGSVORRICHTUNG UND LAMPENBELEUCHTUNGSSYSTEM

DISPOSITIF DE COMMANDE DE LAMPE ET SYSTÈME D'ÉCLAIRAGE DE LAMPE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.06.2016 JP 2016110159
01.06.2016 JP 2016110160**

(43) Date of publication of application:
**10.04.2019 Bulletin 2019/15**

(73) Proprietor: **Mitsuba Corporation
Kiryu-shi, Gunma 376-8555 (JP)**

(72) Inventors:
• **YANAGITA, Yuichi
Kiryu-shi
Gunma 376-8555 (JP)**
• **ISHIDA, Masakatsu
Kiryu-shi
Gunma 376-8555 (JP)**
• **KOBAYASHI, Kazuyuki
Kiryu-shi
Gunma 376-8555 (JP)**

(74) Representative: **Cabinet Laurent & Charras
Le Contemporain
50 Chemin de la Bruyère
69574 Dardilly Cedex (FR)**

(56) References cited:
**WO-A1-2013/065106     JP-A- 2005 343 409
JP-A- 2005 343 409     JP-A- 2013 199 186
JP-A- 2013 199 186**

**Description**

TECHNICAL FIELD

The present invention relates to a lamp body control apparatus and a lamp body lighting system.

BACKGROUND

In the related art, a lamp body lighting system is known in which, when a turn signal switch that is provided on a vehicle is operated, a winker lamp (lamp body) that corresponds to the operated turn signal switch starts blinking, and thereby, a proceeding direction of a vehicle is indicated externally (for example, refer to Patent Document 1). An example of lamp body lighting system of a vehicle is also disclosed in document JP 2013 199186 A.

Further, in a lamp body lighting system, there may be a case in which, for example, a turn signal switch conducts due to rainwater, splash, and the like, a leakage current flows to a lamp body side, and the lamp body is erroneously lighted at an unintended timing by a user. Therefore, the lamp body lighting system described in Patent Document 1 includes a leakage current prevention means that detects a leakage current and that prevents erroneous lighting of the lamp body due to the leakage current.

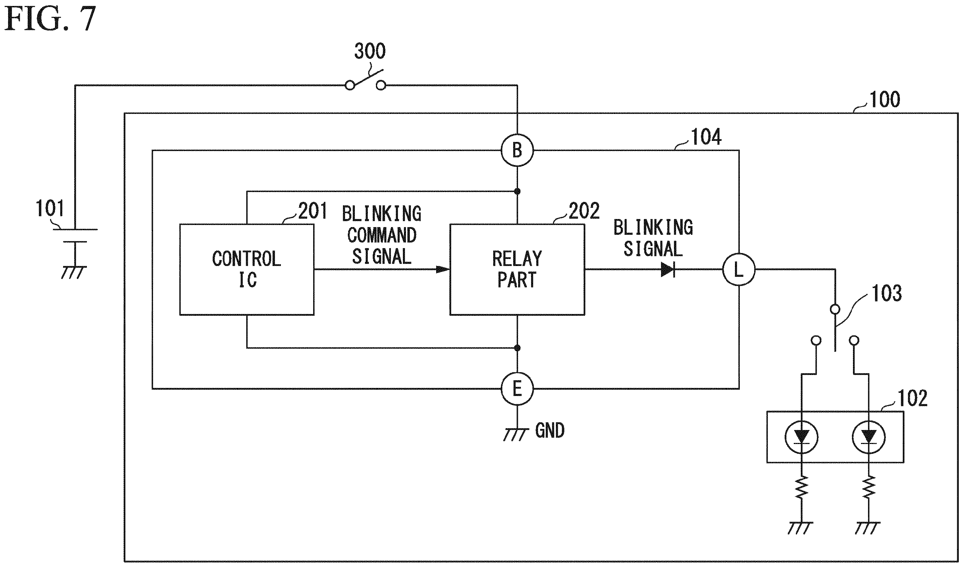

FIG. 7 is a view showing an example of a schematic configuration of a lamp body lighting system of the related art. The lamp body lighting system 100 includes a lamp body 102, a turn signal switch 103, and a lamp body control apparatus 104.

The turn signal switch 103 is provided between the lamp body 102 and a battery 101 that is provided on a vehicle. The turn signal switch 103 is operated by a user and thereby allows any one of right and left light bodies 102 to be displayed to be blinked. Further, the lamp body control apparatus 104 includes a control IC 201 and a turn signal relay (relay part) 202 that is provided between the battery 101 and the turn signal switch 103.

In the lamp body control apparatus 104, when the turn signal switch 103 is operated to any of the right direction and the left direction, the lamp body 102 that corresponds to the operated direction is connected to the battery 101 via the turn signal switch 103, a relay is operated to be opened or closed on the basis of a blinking signal that is output from the control IC 201, and the lamp body 102 of the desired direction is displayed to be blinked (T/S display).

[Related Art Documents]

[Patent Documents]

[Patent Document 1] Japanese Unexamined Patent Application, First Publication No. 2013-33610

SUMMARY OF INVENTION

PROBLEMS TO BE SOLVED BY THE INVENTION

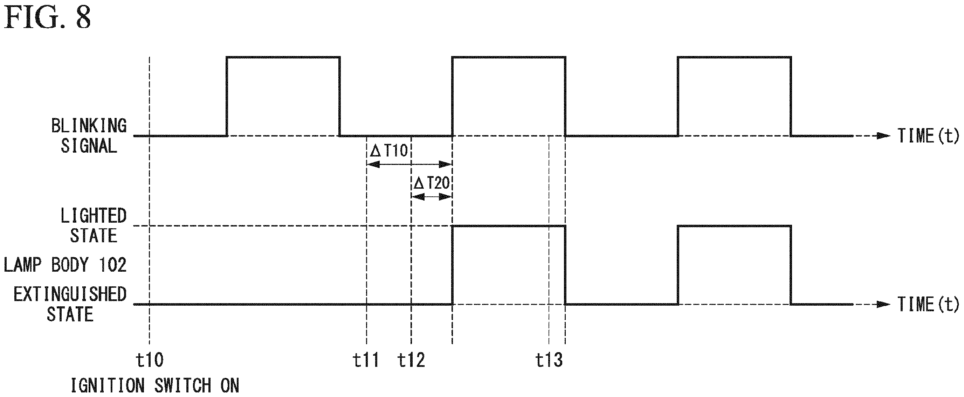

However, in the lamp body control apparatus 104 of the related art, when an ignition switch 300 is turned on (when an engine is started), a blinking signal that allows the lamp body to be displayed to be blinked is output from the control IC 201 to the relay part 202. Therefore, depending on a timing when the turn signal switch 103 is operated by a user, a difference in a timing when the lamp body 102 is blinked occurs. FIG. 8 is a view showing a timing when the lamp body 102 is lighted in the lamp body control apparatus 104 of the related art.

As shown in FIG. 8, when a user turns on the ignition switch 300 at a time point t10 and the engine is started, the control IC 201 outputs a rectangular-wave blinking signal to the relay part 202. When the user turns on the turn signal switch 103 at a time point t11, the relay part 202 outputs a drive voltage that is synchronized with the blinking signal to the lamp body 102. Accordingly, the lamp body 102 is lighted later by a time $\Delta T10$ from the time point t11. However, when the user turns on the turn signal switch 103 at a time point t12, the lamp body 102 is lighted later by a time $\Delta T20$ which is shorter than the time $\Delta T10$ from the time point t12. That is, dispersion of a time from when the turn signal switch 103 is turned on to when the lamp body 102 is lighted occurs. Further, when the user turns on the turn signal switch 103 at a time point t13, the lamp body 102 is lighted at the time point t13 when the turn signal switch 103 is turned on, and soon the lamp body 102 is turned off. That is, there is a possibility that, depending on a timing when the turn signal switch 103 is operated by a user, a difference in a timing when the lamp body 102 is turned off occurs.

Accordingly, in order to solve the problem described above, it is necessary to provide an input part that notifies the lamp body control apparatus 104 of the turn signal switch 103 being turned on. Therefore, it is necessary to increase a terminal that is connected to the input part in the lamp body control apparatus 104, and there is a problem in that the size of the lamp body control apparatus 104 is increased.

An object of an aspect of the present invention is to provide a lamp body control apparatus and a lamp body lighting system in which a blinking timing of a lamp body is constant independently of a timing when a turn signal switch is operated by a user while preventing a size increase.

Further, a novel lamp body control apparatus is required in which a blinking timing of a lamp body is constant independently of a timing when a turn signal switch is operated by a user without increasing the number of terminals.

However, when a leakage current prevention means of the related art is applied to the novel lamp body control apparatus described above, it is necessary to add a new terminal of the lamp body control apparatus, and there is a problem in that the size of the lamp body control apparatus is increased.

Another object of an aspect of the present invention is to provide a lamp body control apparatus and a lamp body lighting system capable of preventing erroneous lighting of a lamp body due to a leakage current while preventing a size increase.

MEANS FOR SOLVING THE PROBLEM

The present invention is directed to a lamp body control apparatus and a lamp body lighting system, the main and subsidiaries aspects of which are defined by the appended claims. An aspect of the present invention is a lamp body control apparatus that controls, in accordance with an operation of a display switch that is provided on a vehicle, blinking of a lamp body that is provided on the vehicle, the lamp body control apparatus including: an output part that outputs a blinking signal which blinks the lamp body to the lamp body from a drive output terminal based on a blinking command signal that commands a blinking timing of the lamp body; an input part that outputs a status signal of a first logic which indicates that a state of the display switch is in an ON state when a signal level from the drive output terminal is a first level and that outputs a status signal of a second logic which indicates that a state of the display switch is in an OFF state when the signal level is a second level that is different from the first level; a control part that outputs the blinking command signal to the output part when a logic of the status signal that is output from the input part is the first logic; and a self-maintaining part that maintains a logic of the status signal based on a logic of the blinking command signal when the lamp body is in a blinking state.

In the lamp body control apparatus described above, the self-maintaining part may be provided between the output part and the input part.

In the lamp body control apparatus described above, the output part and the input part may be connected to the drive output terminal such that a logic that allows the lamp body to be lighted in the blinking signal and a logic which indicates that the display switch is in an ON state in the status signal are matched with each other.

The lamp body control apparatus described above may further include a level adjustment part that outputs a signal of the second level to the input part when detecting a leakage current that occurs on the lamp body side by comparing a preset threshold value to the signal level from the drive output terminal.

In the lamp body control apparatus described above, the level adjustment part may be provided between the input part and the drive output terminal, may output a signal of the second level to the input part when the signal level from the drive output terminal is less than the threshold value, and may output a signal of the first level to the input part when the signal level is equal to or more than the threshold value.

In the lamp body control apparatus described above, the self-maintaining part may be provided between the output part and a connection point of the input part and the level adjustment part.

In the lamp body control apparatus described above, the output part and the input part may be connected to the drive output terminal such that a logic that allows the lamp body to be lighted in the blinking signal and a logic which indicates that the display switch is in an ON state in the status signal are matched with each other.

Another aspect of the present invention is a lamp body lighting system that includes: a lamp body control apparatus described above; and a lamp body that blinks based on a blinking signal which is output via the drive output terminal from the lamp body control apparatus.

The lamp body lighting system described above may further include a bias resistance that is connected in parallel with respect to the lamp body.

ADVANTAGE OF THE INVENTION

According to an aspect of the present invention, it is possible to provide a lamp body control apparatus and a lamp body lighting system in which a blinking timing of a lamp body is constant independently of a timing when a turn signal switch is operated by a user while preventing a size increase.

Further, according to an aspect of the present invention, it is possible to provide a lamp body control apparatus and a lamp body lighting system capable of preventing erroneous lighting of a lamp body due to a leakage current while preventing a size increase.

BRIEF DESCRIPTION OF THE DRAWINGS

FIG. 1 is a top view schematically showing a motorcycle that includes a lamp body lighting system in a first embodiment.
FIG. 2 is a view showing an example of a schematic configuration of the lamp body lighting system in the first embodiment.
FIG. 3 is a view showing a circuit example of a lamp body control apparatus in the first embodiment.
FIG. 4 is a view showing a self-maintaining part in the first embodiment.
FIG. 5 is a view showing an example of a schematic configuration of a lamp body lighting system in a second embodiment.
FIG. 6 is a view showing a circuit example of the lamp body lighting system in the second embodiment.
FIG. 7 is a view showing an example of a schematic configuration of a lamp body lighting system of the related art.
FIG. 8 is a view showing a timing when a lamp body is lighted in a lamp body control apparatus of the related art.

DESCRIPTION OF THE EMBODIMENTS

Hereinafter, embodiments of the present invention are described, but the following embodiments do not limit the invention according to claims. Further, all of the combinations of features described in the embodiments are not necessarily indispensable for solving the problem addressed by the invention. In the drawings, the same reference numerals may be given to the same or similar parts, and redundant descriptions may be omitted.
Hereinafter, a lamp body lighting system 1 of an embodiment is described with reference to the drawings.

(First embodiment)

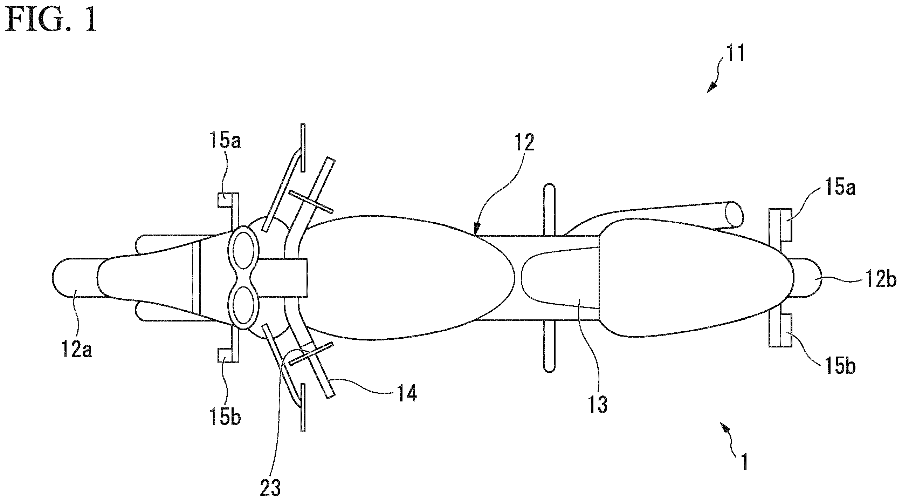

FIG. 1 is a top view schematically showing a motorcycle that includes the lamp body lighting system 1 in a first embodiment. As shown in FIG. 1, a front wheel 12a and a rear wheel 12b are provided on a vehicle body 12 of a motorcycle 11 as a vehicle. A driver who is seated on a seat 13 that is provided on a middle part of the vehicle body 12 operates a handle 14 and allows the motorcycle 11 to travel.

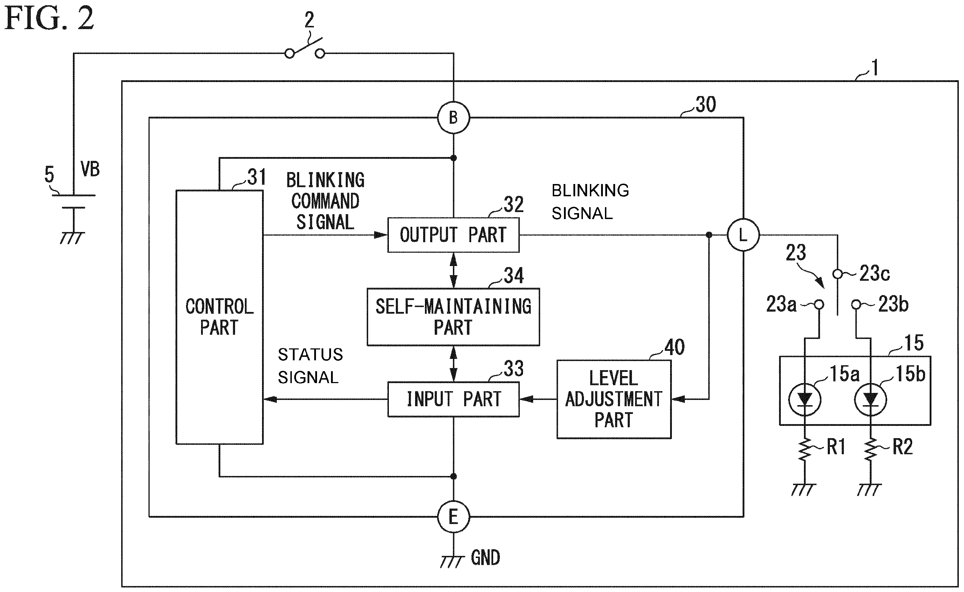

FIG. 2 is a view showing an example of a schematic configuration of the lamp body lighting system 1 in the first embodiment.
As shown in FIG. 1 and FIG. 2, the lamp body lighting system 1 includes a lamp body 15, a display switch 23, and a lamp body control apparatus 30.
As shown in FIG. 1, a right turn signal lamp 15a as the lamp body 15 is provided on a right side at frontward and rearward positions of the vehicle body 12. A left turn signal lamp 15b as the lamp body 15 is provided on a left side at frontward and rearward positions of the vehicle body 12. As shown in FIG. 1, a display switch 23 is arranged on a part of the handle 14 of the vehicle body 12 to be operable from the outside of the motorcycle 11. For example, the lamp body 15 is a light-emitting diode.
Two right turn signal lamps 15a are connected in parallel with each other. One of the two right turn signal lamps 15a is arranged at a frontward position of the vehicle body 12. The other of the two right turn signal lamps 15a is arranged at a rearward position of the vehicle body 12. Two left turn signal lamps 15b are connected in parallel with each other. One of the two left turn signal lamps 15b is arranged at a frontward position of the vehicle body 12. The other of the two left turn signal lamps 15b is arranged at a rearward position of the vehicle body 12.
By a driver operating the display switch 23, it is possible to allow any one of the right turn signal lamp 15a and the left turn signal lamp 15b to perform a blinking display, that is, to perform a turn signal display (T/S display), and it is possible to notify another vehicle and the like of a proceeding direction of the motorcycle 11. That is, the display switch 23 is a turn signal switch for allowing any one of the right turn signal lamp 15a and the left turn signal lamp 15b to perform a blinking display, that is, to perform a T/S display.
As shown in FIG. 2, for example, the display switch 23 includes a common connection point 23c that is connected to a drive output terminal L, a right connection point 23a that is connected to the right turn signal lamp 15a, and a left connection point 23b that is connected to the left turn signal lamp 15b. When the display switch 23 is switched on (operated) by an operation of the driver, the common connection point 23c is connected selectively to any one of the right connection point 23a and the left connection point 23b. When the display switch 23 is switched on, that is, turned on, any one of the right turn signal lamp 15a and the left turn signal lamp 15b is connected to the drive output terminal L. Then, the right turn signal lamp 15a or the left turn signal lamp 15b that is connected to the drive output terminal L is blinked on the basis of a blinking signal that is output from the lamp body control apparatus 30. The display switch 23 may include a hazard switch for allowing the right turn signal lamp 15a and the left turn signal lamp 15b to perform a blinking display simultaneously, that is, to perform a hazard display. That is, by the driver switching on the display switch 23, the right turn signal lamp 15a and the left turn signal lamp 15b are allowed to perform a blinking display simultaneously, that is, to perform a hazard display, and thereby, the driver may notify an emergency stopping on a road due to a failure and the like of another vehicle and the like.

As shown in FIG. 2, a drive electric source terminal B and the drive output terminal L are provided on the lamp body control apparatus 30. The drive electric source terminal B is connected to an electric source 5 that is provided on the vehicle body 12. In the present embodiment, by the driver switching on an ignition switch 2, an engine (not shown) of the motorcycle 11 is started, and it is possible to supply a voltage VB of the electric source 5 to the lamp body control apparatus 30 via the drive electric source terminal B. For example, the electric source 5 is a battery. The voltage VB that is supplied to the drive electric source terminal B via the ignition switch 2 from the electric source 5 is output from the drive output terminal L as a blinking signal that blinks the lamp body 15. That is, when the display switch 23 is turned on, the lamp body control apparatus 30 outputs the blinking signal from the drive output terminal L so as to allow at least one of the turn signal lamp 15a and the turn signal lamp 15b to perform a blinking display.

As shown in FIG. 2, the lamp body control apparatus 30 includes a control part 31, an output part 32, an input part 33, a self-maintaining part 34, and a level adjustment part 40.

A status signal that indicates a state of the display switch 23 is output from the input part 33 to the control part 31.

The control part 31 determines whether or not the display switch 23 is turned on based on the status signal that indicates a state of the display switch 23 and that is output from the input part 33. This status signal is a High-Low binarized signal. For example, when the display switch 23 is turned on, the status signal is a High signal. When the display switch 23 is turned off, the status signal is a Low signal. That is, when the status signal that is output from the input part 33 is the High (first logic) signal, the control part 31 determines that the display switch 23 is turned on. On the other hand, when the status signal that is output from the input part 33 is the Low (second logic) signal, the control part 31 determines that the display switch 23 is turned off.

When it is determined that the display switch 23 is turned on based on the status signal that indicates the state of the display switch 23 and that is output from the input part 33, the control part 31 outputs a blinking command signal that commands a timing of the blinking (hereinafter, referred to as a "blinking timing") of the lamp body 15 to the output part 32. For example, the blinking command signal is a High-Low binarized signal. When it is determined that the display switch 23 is turned off, the control part 31 outputs a Low signal to the output part 32. That is, when it is determined that the display switch 23 is turned off, the control part 31 does not output the blinking command signal to the output part 32.

The output part 32 generates a blinking signal that allows the lamp body 15 to blink from the voltage VB on the basis of the blinking command signal that is output from the control part 31. Then, the output part 32 outputs the generated blinking signal from the drive output terminal L. For example, the blinking signal is a signal that repeats High (for example, the voltage VB) and Low (for example, 0V) at a constant cycle in response to the blinking timing that is commanded by the blinking command signal. Thereby, the blinking signal is supplied to the lamp body 15 via the display switch 23 that is connected to the drive output terminal L. Thereby, the lamp body 15 blinks at a constant cycle on the basis of the blinking signal that is supplied from the output part 32. For example, the output part 32 is a voltage conversion circuit by which a voltage is converted to an output voltage for allowing the lamp body 15 to be lighted or a current amplifier circuit by which a current is amplified to a current for allowing the lamp body 15 to be lighted.

The input part 33 outputs a status signal that indicates a state of the display switch 23 on the basis of the signal level of the drive output terminal L that is acquired via the level adjustment part 40. That is, the input part 33 outputs a status signal of a first logic which indicates that the state of the display switch 23 is in an ON state when the signal level from the drive output terminal L is a first level. On the other hand, the input part 33 outputs a status signal of a second logic which indicates that the state of the display switch 23 is in an OFF state when the signal level from the drive output terminal L is a second level that is different from the first level. For example, the first level corresponds to a signal voltage of substantially 0V, that is, a Low voltage level. The second level is a case in which the signal voltage is a voltage VB. For example, the voltage VB corresponds to a High voltage level.

For example, the drive output terminal L is set to be in the first level when the display switch 23 is in an ON state. On the other hand, the drive output terminal L is set to be in the second level when the display switch 23 is in an OFF state. Accordingly, when the display switch 23 is in an ON state, a signal of the first level is input to the input part 33 via the level adjustment part 40. On the other hand, when the display switch 23 is in an OFF state, a signal of the second level is input to the input part 33 via the level adjustment part 40.

For example, the input part 33 sets two threshold values $V_{th1}$, $V_{th2}$ ($V_{th2}<V_{th1}$). When the voltage level of the drive output terminal L is equal to or more than $V_{th1}$, the input part 33 outputs the status signal which indicates the ON state of the display switch 23 to the control part 31. On the other hand, when the voltage level of the drive output terminal L is equal to or less than $V_{th2}$, the input part 33 outputs the status signal which indicates the OFF state of the display switch 23 to the control part 31. In this case, $V_{th1}$ is $V_{th2}$ or more and is a value of the first level or less. $V_{th2}$ is the second level or more and is a value less than $V_{th1}$. That is, a signal of $V_{th1}$ or more is a signal of the first level. A signal of $V_{th2}$ or less is a signal of the second level.

For example, the status signal is a High-Low binarized signal. For example, the input part 33 outputs a High status signal as a status signal which indicates the ON state of the display switch 23 to the control part 31. On the other hand, the input part 33 outputs a Low status signal as a status signal which indicates the OFF state of the display switch 23 to the control part 31.

The level adjustment part 40 outputs a signal of the second level to the input part 33 when detecting a leakage current that occurs on the lamp body 15 side by comparing a preset threshold value to the signal level from the drive output terminal L. For example, the level adjustment part 40 converts the signal level of the signal that is supplied from the drive output terminal L into the second level when detecting a leakage current that occurs on the lamp body 15 side. Then, the level adjustment part 40 outputs the signal that is converted into the second level to the input part 33. Thereby, the level adjustment part 40 prevents erroneous lighting of the lamp body 15 due to the leakage current.

For example, in general, there is a case in which a leakage current flows to the lamp body 15 side due to an external factor such as the weather. As shown in FIG. 1, in the motorcycle 11, since the display switch 23 is provided in the vicinity of the handle 14, when the display switch 23 becomes wet with rain and a leakage current occurs, there is a possibility that the lamp body 15 is erroneously lighted due to the leakage current. For example, when the leakage current flows to the lamp body 15 side, the signal level of the drive output terminal L is decreased. Accordingly, when it is determined whether the display switch 23 is in an ON state or in an OFF state based on the signal level of the drive output terminal L, the control part 31 misidentifies that the display switch 23 is changed to the ON state according to the decrease of the signal level of the drive output terminal L which occurs due to the leakage current. As a result, the control part 31 outputs a blinking command signal and lights the lamp body 15. Accordingly, for example, when the voltage level of the drive output terminal L is decreased due to the leakage current, the level adjustment part 40 converts the signal level of the signal that is supplied from the drive output terminal L into a second level and outputs the signal to the input part 33. For example, when the voltage level of the drive output terminal L is less than a threshold value Vth, the level adjustment part 40 outputs a signal of the first level to the input part 33. On the other hand, when the voltage level of the drive output terminal L is the threshold value Vth or more, the level adjustment part 40 outputs a signal of the second level to the input part 33. The threshold value Vth is a value of a voltage that is higher than the voltage of the drive output terminal L that is generated due to the leakage current.

The self-maintaining part 34 is provided between the output part 32 and the input part 33. When the lamp body 15 is in a blinking state, the logic of the status signal is maintained based on the logic of the blinking command signal. As described above, the input part 33 outputs a status signal that indicates a state of the display switch 23 on the basis of a signal level of the signal that is output from the level adjustment part 40. For example, when the signal level of the signal that is output from the level adjustment part 40 is equal to or less than $V_{th2}$, the input part 33 outputs a status signal which indicates an OFF state of the display switch 23 to the control part 31. However, there is a case in which, when the display switch 23 is in an ON state, the signal level of the drive output terminal L becomes equal to or less than $V_{th2}$.

That is, since the blinking signal that allows the lamp body 15 to be blinked is a signal that repeats High (for example, the voltage VB) and Low (for example, 0V) at a constant cycle, even when the output part 32 outputs the blinking signal to the lamp body 15 via the drive output terminal L to allow the lamp body 15 to be blinked, there is a case in which the signal level of the drive output terminal L becomes equal to or less than $V_{th2}$. In this case, the input part 33 outputs a status signal which indicates an OFF state of the display switch 23 to the control part 31 and stops the blinking of the lamp body 15. That is, there is a possibility that the input part 33 recognizes that the display switch 23 is in the OFF state in spite of the display switch 23 being in the ON state. In order to solve this problem, the self-maintaining part 34 maintains the logic of the status signal to be High when the lamp body 15 is in a blinking state. Further, when the display switch 23 becomes the OFF state, the self-maintaining part 34 resets a logic maintaining in which the logic of the status signal is maintained to be High.

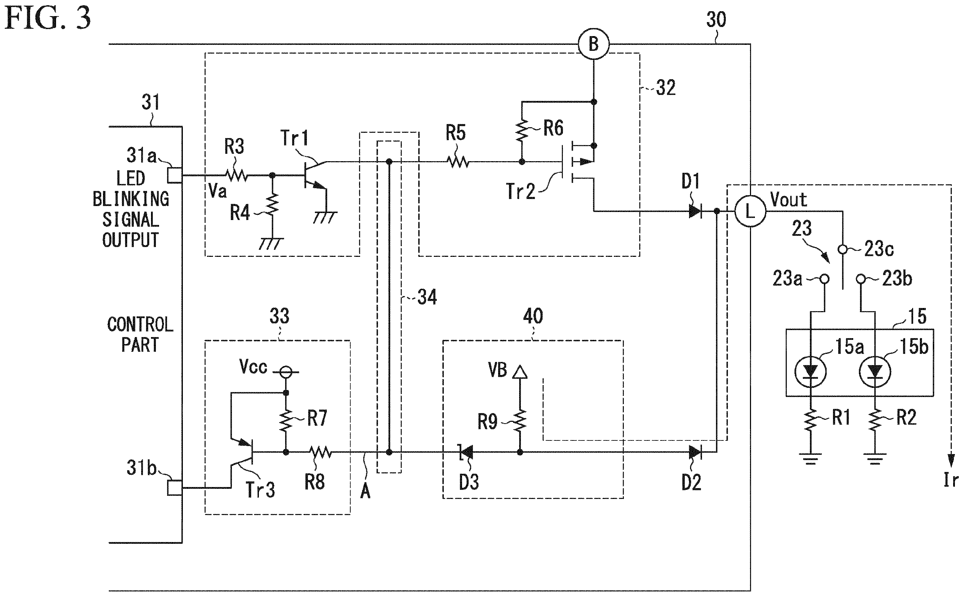

Hereinafter, a circuit example of the lamp body control apparatus 30 in the present embodiment is described. FIG. 3 is a view showing a circuit example of the lamp body control apparatus 30 in the first embodiment.

The output part 32 includes resistances R3 to R6, a switching element Tr1, and a switching element Tr2. The switching elements Tr1, Tr2 may be constituted of any one of an IGBT (Insulated-Gate Bipolar Transistor), a MOS-FET (Metal-Oxide Semiconductor Field-Effect Transistor), and a BJT (Bipolar Junction Transistor). The present embodiment is described using a case in which the switching element Tr1 is a NPN-type BJT, and the switching element Tr2 is a P-channel MOS-FET.

The resistance R3 is an input resistance of the switching element Tr1 and is connected to and between a base of the switching element Tr1 and an output terminal 31a of the control part 31. The resistance R4 is connected to and between a base and an emitter of the switching element Tr1. Thereby, when a High blinking command signal is output to the switching element TR1 via the resistance R3 from the output terminal 31a of the control part 31, the state between a collector and the emitter of the switching element Tr1 becomes an ON state. On the other hand, when a Low blinking command signal is output to the switching element Tr1 via the resistance R3 from the output terminal 31a of the control part 31, the state between the collector and the emitter of the switching element Tr1 becomes an OFF state.

The resistance R5 is connected to and between the collector of the switching element Tr1 and a gate of the switching element Tr2. The resistance R6 is connected to and between the gate and a source of the switching element Tr2. The source of the switching element Tr2 is connected to the drive electric source terminal B, and a drain of the switching element Tr2 is connected to the drive output terminal L via a diode D1. The diode D1 is a diode for preventing a back current from the drive output terminal L. An anode of the diode D1 is connected to the source of the switching element Tr2, and a cathode of the diode D1 is connected to the drive output terminal L. Thereby, when the state between the collector and the emitter of the switching element Tr1 becomes an ON state, the state between the source and a collector of the switching element Tr2 becomes an ON state, and therefore, the voltage VB is applied to the drive output terminal L. On the other hand, when the state between the collector and the emitter of the switching element Tr1 becomes an OFF state, the state between the source and the collector of the switching element Tr2 becomes an OFF state, and therefore, in a case where the blinking command signal is output to the control part 31, the voltage 0V is applied to the drive output terminal L.

The input part 33 includes resistances R7, R8 and a transistor Tr3. The transistor Tr3 may be constituted of any one of an IGBT (Insulated-Gate Bipolar Transistor), a MOS-FET (Metal-Oxide Semiconductor Field-Effect Transistor), and a BJT (Bipolar Junction Transistor). The present embodiment is described using a case in which the switching element Tr3 is a PNP-type BJT.

A first end of the resistance R8 is connected to a base of the switching element Tr3. The resistance 7 is connected to and between the base and an emitter of the switching element Tr3. The emitter of the switching element Tr3 is connected to an electric source Vcc, and a collector of the switching element Tr3 is connected to the control part 31. The electric source Vcc is an electric source voltage that is readable by the control part 31 and is a voltage of a voltage level that is recognized as High by the control part 31. Accordingly, when the display switch 23 is in an OFF state, the base of the switching element Tr3 becomes High, and therefore, the switching element Tr3 becomes an OFF state. Accordingly, a Low status signal is input to an input terminal 31b of the control part 31. On the other hand, when the display switch 23 is operated from an OFF state to an ON state, the base of the switching element Tr3 is changed from High to Low, and therefore, the switching element Tr3 is changed from an OFF state to an ON state. Accordingly, a High status signal is input to the input terminal 31b of the control part 31.

The self-maintaining part 34 connects the collector of the switching element Tr1 and a point A at a second end of the resistance R8. That is, the self-maintaining part 34 has a function of matching a voltage level (logic) of the collector of the switching element Tr1 with a voltage level (logic) of the second end of the resistance R8. In other words, the self-maintaining part 34 has a function of allowing the voltage level (logic) of the collector of the switching element Tr1 to reflect the voltage level of the second end of the resistance R8. The self-maintaining part 34 aims at matching the logic of the voltage level of the collector of the switching element Tr1 with the logic of the voltage level of the point A during the display switch 23 is in an ON state and the High blinking command signal is output from the output terminal 31a of the control part 31.

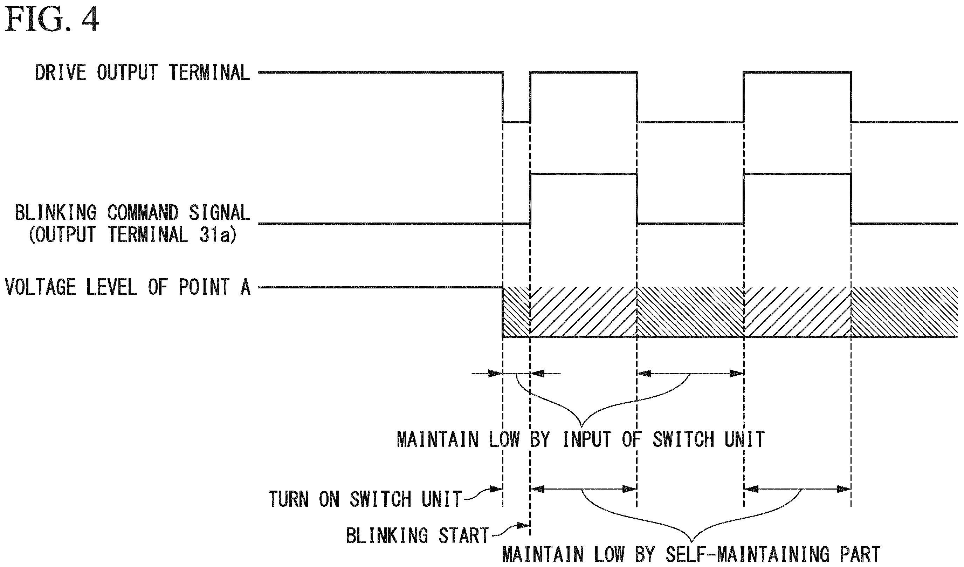

FIG. 4 is a view showing the self-maintaining part 34 in the first embodiment.

As shown in FIG. 4, when the display switch 23 is operated to ON, the voltage level of the drive output terminal L is changed from High to Low. Then, the voltage level of the point A is changed from High to Low, and the High status signal is input to the input terminal 31b of the control part 31. Therefore, the control part 31 determines that the display switch 23 is turned on and outputs a blinking command signal from the output terminal 31a. When this blinking command signal is Low, the voltage level of the collector of the switching element Tr1 is High. Accordingly, a Low blinking signal is output from the drive output terminal L, and therefore, the voltage level of the drive output terminal L is Low. Accordingly, the voltage level of the point A also becomes Low, and a High status signal is input to the input terminal 31b of the control part 31. Accordingly, the control part 31 determines that the display switch 23 is in an ON state and continues outputting the blinking command signal from the output terminal 31a.

On the other hand, when the blinking command signal is High, the voltage level of the collector of the switching element Tr1 is Low. Accordingly, a High blinking signal is output from the drive output terminal L, and therefore, the voltage level of the drive output terminal L is High. When the self-maintaining part 34 is not present, the voltage level of the point A also becomes High, and a Low status signal is input to the input terminal 31b of the control part 31. Accordingly, the control part 31 determines that the display switch 23 is in an OFF state and stops outputting the blinking command signal from the output terminal 31a. That is, the control part 31 stops outputting the blinking command signal and stops blinking of the lamp body 15 in spite of the display switch 23 being in the ON state. The present embodiment includes the self-maintaining part 34 that matches the voltage level of the collector of the switching element Tr1 with the voltage level of the point A during the High blinking command signal is output from the output terminal 31a of the control part 31. Accordingly, even when the voltage level of the drive output terminal L is High, the voltage level of the point A is maintained to be the voltage level of the collector of the switching element Tr1, that is, Low. Thereby, the High status signal is input to the input terminal 31b of the control part 31. Therefore, even when the blinking command signal is High, it is possible for the control part 31 to determine that the display switch 23 is in an ON state and continue outputting the blinking command signal from the output terminal 31a.

For example, the level adjustment part 40 includes an electric source part (for example, VB) that is provided in parallel with the lamp body 15, a resistance part (for example, a resistance R9) that is provided in series with the electric source part, and a filter part (for example, D3) that cuts off a voltage decrease of a threshold value or less.

Specifically, the level adjustment part 40 includes the resistance R9 and a Zener diode D3.

The resistance R9 is a pull-up resistance that pulls up the connection point of an anode of a diode D2 and an anode of the Zener diode D3 to the voltage VB.

A cathode of the Zener diode D3 is connected to the point A.

Hereinafter, a detection method of a leakage current in the level adjustment part 40 is described.

For example, a leakage current from the lamp body control apparatus 30 to the lamp body 15 occurs due to the reduction of an insulation resistance according to degradation of the display switch 23, a case in which the display switch 23 becomes wet with rain, and the like. At this time, when the resistance component of the display switch 23 is a resistance Rs and the leakage current is a leakage current Ir, a voltage of $Vr = Rs \times Ir$ occurs at the drive output terminal L. In the present embodiment, the resistance components of the resistances R1, R2 are sufficiently small compared to the resistance Rs and are negligible. Here, Vr is represented by the following expression.

$$Vr = Rs \times Ir = VB \times (Rs / (R9 + Rs)) \cdots (1)$$

Accordingly, it becomes possible by the resistance value of the resistance Rs to adjust the voltage Vr of the drive output terminal L that occurs by the leakage current Ir.

The Zener diode D3 is a diode by which, when a voltage is applied in a reverse direction, a Zener breakdown (avalanche breakdown) occurs at a certain voltage value (hereinafter, referred to as a "Zener voltage"), and it is possible to obtain a constant voltage regardless of a flowing current value. The Zener diode D3 is used as a voltage reference. That is, when a voltage potential difference between both ends of the Zener diode D3 exceeds a Zener voltage, the Zener breakdown occurs, that is, the point A is changed to Low. Accordingly, the Zener voltage and the resistance value of the resistance R9 are set such that the voltage difference between the voltage of the point A and the voltage Vr of the drive output terminal L that occurs by the leakage current Ir becomes the Zener voltage or less. Thereby, in a state where the display switch 23 is in an OFF state, even when the voltage Vr occurs at the drive output terminal L by the leakage current Ir, since the point A is not changed to Low, the signal level that is input to the input part 33 is equal to or more than $V_{th1}$, and erroneous lighting of the lamp body 15 is prevented. When the drive output terminal L becomes Low, which is a voltage that is sufficiently lower than Vr by the display switch 23 being turned on, since the Zener breakdown (avalanche breakdown) occurs and the point A is changed to Low, the signal level that is input to the input part 33 becomes equal to or less than $V_{th2}$. Thereby, when the display switch 23 is turned on, it is possible for the lamp body control apparatus 30 to reliably blink the lamp body 15. In other words, the level adjustment part 40 includes a function of changing the voltage level of the point A to Low when the voltage of the drive output terminal L becomes less than the threshold value Vth that is set in advance.

As described above, the lamp body control apparatus 30 in the first embodiment is a lamp body control apparatus that controls, in accordance with an operation of a display switch that is provided on a vehicle, blinking of a lamp body that is provided on the vehicle, the lamp body control apparatus 30 including: an output part 32 that outputs a blinking signal which blinks the lamp body 15 to the lamp body 15 from a drive output terminal L based on a blinking command signal that commands a blinking timing of the lamp body 15; an input part 33 that outputs a status signal of a first logic which indicates that a state of the display switch 23 is in an ON state when a signal level from the drive output terminal L is a first level and that outputs a status signal of a second logic which indicates that a state of the display switch 23 is in an OFF state when the signal level from the drive output terminal L is a second level that is different from the first level; a control part 31 that outputs the blinking command signal to the output part 32 when a logic of the status signal that is output from the input part 33 is the first logic; and a level adjustment part 40 that converts the signal level from the drive output terminal L into the second level and outputs the signal that is converted to the second level to the input part 33 when detecting a leakage current that occurs on the lamp body 15 side by comparing a preset threshold value Vth to the signal level from the drive output terminal L.

Thereby, it is possible to detect that the display switch 23 is turned on based on the signal level that is supplied from the drive output terminal L, and therefore, it is possible to allow the blinking timing of the lamp body 15 to be constant without adding a new terminal. Therefore, it is possible to control the blinking timing of the lamp body to be constant independently of a timing when the turn signal switch is operated by a user while preventing a size increase. Further, the level adjustment part 40 outputs a signal of the second level to the input part 33 when detecting a leakage current that occurs on the lamp body 15 side by comparing the threshold value Vth to the signal level from the drive output terminal. Thereby, it is possible to prevent erroneous lighting of the lamp body 15 due to the leakage current.

Further, by changing the resistance R9 of the level adjustment part 40 or the Zener voltage of the Zener diode D3, it is possible to easily adjust a detection sensitivity for detecting that the insulation property of the display switch 23 is decreased due to rainwater and the like. Accordingly, it is possible to easily adjust the threshold value Vth, the degree of freedom of the lamp body 15 is increased, and it is possible to contribute to the reduction of the size and the weight of the lamp body 15.

Further, it is possible for the lamp body control apparatus 30 in the first embodiment to prevent a blinking operation of the lamp body at an unintended timing of a user without separately providing a sensor that detects a leakage current which occurs on the lamp body 15 side.

Further, the lamp body control apparatus 30 in the first embodiment includes the level adjustment part 40 that detects a leakage current inside the lamp body control apparatus 30, and therefore, it becomes possible to downsize the lamp body 15 compared to a case of the related art in which the lamp body 15 includes a function of detecting a leakage current.

Further, as described above, by the self-maintaining part 34, it becomes possible for the lamp body control apparatus 30 in the first embodiment to maintain the signal level of the status signal after blinking of the lamp body 15 is started, and it is possible to integrate the output part 32 and the input part 33, that is, to share the output of the output part 32 and the input of the input part 33.

(Second embodiment)

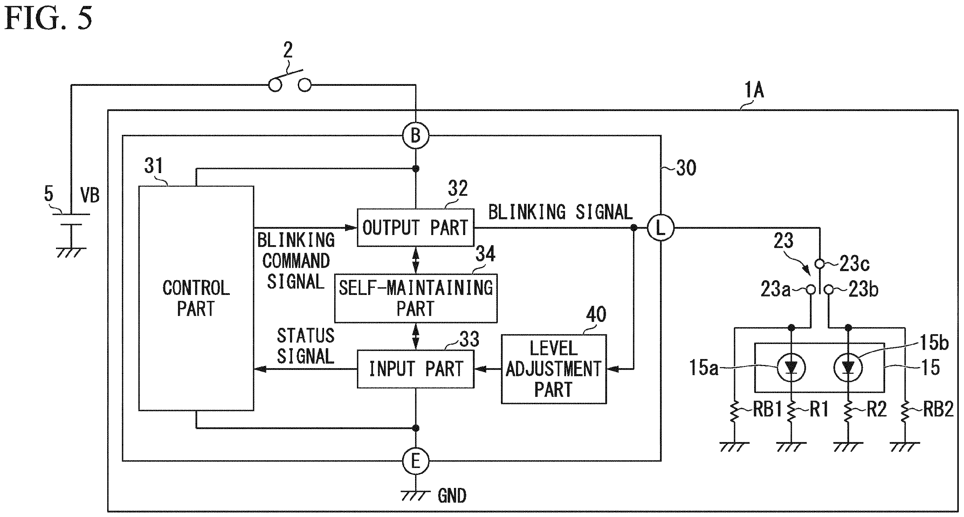

FIG. 5 is a view showing an example of a schematic configuration of a lamp body lighting system 1A in a second embodiment. The lamp body lighting system 1A in the second embodiment has a configuration in which the detection performance of a leakage current in the level adjustment part 40 is further improved compared to the first embodiment.

The lamp body lighting system 1A includes the lamp body 15, the display switch 23, the lamp body control apparatus, and a bias resistance RB.

Hereinafter, a circuit example of the lamp body lighting system 1A in the second embodiment is described. FIG. 5 is a view showing a circuit example of the lamp body lighting system 1A in the second embodiment.

In the lamp body lighting system 1 in the first embodiment, even when seawater, rainwater, and the like enter the inside of the display switch 23 and the resistance value of the insulation resistance becomes relatively low, it is desirable that the lamp body 15 be not erroneously lighted. That is, even when seawater, rainwater, and the like enter the inside of the display switch 23 and the resistance value of the insulation resistance becomes relatively low, it is desirable that it be recognized that a leakage current due to insulation degradation of the display switch 23 has occurred, and a Low status signal be input to the input terminal 31b of the control part 31. In that case, by increasing a current Iin that flows out toward the lamp body 15 side from the drive output terminal L, the threshold value Vth is decreased. Thereby, even when a resistance Rs, which is an insulation degradation resistance component of the display switch 23 is low, a voltage decrease by the resistance Rs becomes high, and it becomes possible to prevent the signal of the first level from being input to the input part 33 when the display switch 23 is in an OFF state. For example, by decreasing the resistance value of the resistance R9 of the level adjustment part 40, it is possible to decrease the threshold value Vth and increase the current Iin.

However, when the current Iin is increased, even when the blinking signal that is output from the drive output terminal L is Low, there is a case in which the lamp body 15 is dimmed by the current Iin that flows out toward the lamp body 15 side from the drive output terminal L. Accordingly, the lamp body lighting system 1A in the second embodiment includes the bias resistance RB that is connected in parallel with respect to the lamp body 15 so as to prevent the dimming of the lamp body 15 by the current Iin.

Hereinafter, the bias resistance RB in the second embodiment is described.

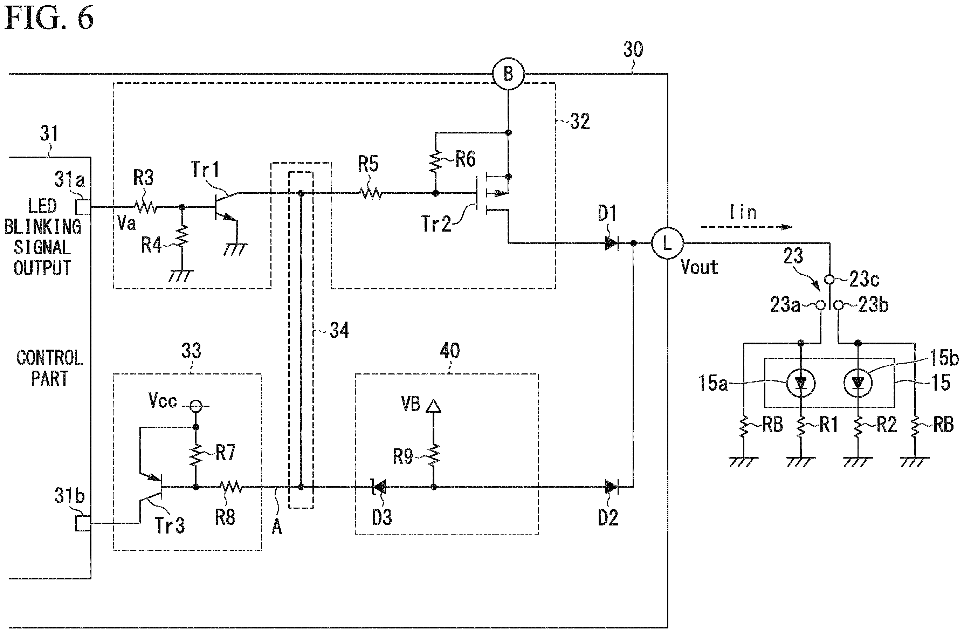

As shown in FIG. 6, in a case where the current Iin flows out toward the lamp body 15 side from the drive output terminal L, it is possible to cut off the current that flows to the lamp body 15 until the voltage decrease of both ends of the bias resistance RB exceeds a forward voltage VF of the lamp body 15. That is, when the expression shown below is satisfied, a current does not flow to the lamp body 15 side.

$$VF > \text{the resistance value of the bias resistance } RB \times Iin \cdots (2)$$

Accordingly, by setting the resistance value of the bias resistance RB so as to satisfy the relationship of Expression (2) described above, it is possible to set a desired threshold value Vth, and it is possible to increase the current Iin. Accordingly, it is possible to improve the accuracy of the leakage current in the level adjustment part 40 while preventing the dimming of the lamp body 15 by the current Iin.

As described above, the lamp body lighting system 1A in the second embodiment includes a bias resistance that is connected in parallel with respect to the lamp body 15. Accordingly, the lamp body lighting system 1A provides an advantage similar to the first embodiment, and it is possible to improve the accuracy of the leakage current in the level adjustment part 40 while preventing the dimming of the lamp body 15 by the current Iin.

Each part of the lamp body control apparatus 30 may be realized by hardware, may be realized by software, or may be realized by the combination of hardware and software.

The lamp body control apparatus 30 in the embodiments described above may be realized by a computer. In that case, a program for realizing this function may be recorded in a computer-readable recording medium, and the program recorded in the recording medium may be read into and executed on a computer system to thereby realize the function. The term "computer system" used herein includes an OS or hardware such as peripherals. Further, the term "computer-readable recording medium" refers to portable media such as a flexible disk, a magneto-optical disc, a ROM, and a CD-ROM and a storage device such as a hard disk embedded in the computer system. Further, the term "computer-readable recording medium" may include a recording medium that holds a program dynamically for a short period of time like a network such as the Internet or a communication line when a program is transmitted through a communication line such as a telephone line and may include a recording medium that stores a program for a certain period of time like a volatile memory in a computer system which serves as a server or a client in that case. Further, the above program may be a program for realizing some of the functions described above, may be a program capable of realizing the above functions by the combination with a program already recorded in the computer system, or may be a program that is realized by using a programmable logic device such as a FPGA (Field-Programmable Gate Array).

Although the embodiments of the invention have been described in detail with reference to the drawings, a specific configuration is not limited to the embodiments, and designs and the like without departing from the scope of the invention are also included.

DESCRIPTION OF THE REFERENCE SYMBOLS

| | |
|---|---|
| 15: | LAMP BODY |
| 23: | DISPLAY SWITCH |
| 30: | LAMP BODY CONTROL APPARATUS |
| 31: | CONTROL PART |
| 32: | OUTPUT PART |
| 33: | INPUT PART |
| 34: | SELF-MAINTAINING PART |
| 40: | LEVEL ADJUSTMENT PART |
| RB: | BIAS RESISTANCE |

**Claims**

1. A lamp body control apparatus for controlling, in accordance with an operation of a display switch (23) that is provided on a vehicle, blinking of a lamp body (15) that is provided on the vehicle, the lamp body control apparatus comprising:

   a drive output terminal (L) that is electrically connected to the display switch (23) and that supplies a current, as a blinking signal, to the lamp body (15) via the display switch (23) to cause the lamp body (15) to blink;
   an input part (33) that has an input terminal (A) which is connected via a level adjustment part (40) to the drive output terminal (L), said input part (33) is configured to output a status signal representative of a state of the display switch (23), said status signal having a first logic level when the input terminal of the input part (33) is at a first voltage level, said first logic level being representative of an ON state of the display switch (23), and said status signal having a second logic level when the input terminal of the input part (33) is at a second voltage level, said second logic level being representative of an OFF state of the display switch (23);
   a control part (31) that outputs a blinking command signal when the status signal that is output from the input part (33) has the first logic level;
   an output part (32) that generates the blinking signal and outputs the blinking signal to the lamp body (15) via the drive output terminal (L) when the blinking command signal is output from the control part (31);
   the level adjustment part (40) that is connected to the drive output terminal (L), that outputs a signal of the second level to the input terminal of the input part (33) when the display switch (23) is in the OFF state, and that outputs a signal of the first level to the input terminal of the input part (33) when the display switch (23) is operated to an ON state; and
   a self-maintaining part (34) that supplies a signal, based on a logic level of the blinking command signal, from the output part (32) to the input terminal (31b) to maintain a logic level of the status signal that is generated by the input part (33) when the output part (32) supplies the current that causes the lamp body (15) to blink to the drive output terminal (L),

**characterized in that**

the output part (32) has a bipolar transistor (Tr1) and a field-effect transistor (Tr2), the bipolar transistor (Tr1) having a base terminal connected to the control part (31) and having a collector terminal connected to a gate terminal of the field-effect transistor (Tr2), the field-effect transistor (Tr2) having a drain terminal electrically connected to the drive output terminal (L) and having a source terminal connected to an electric source (Vcc); and the level adjustment part (40) has a Zener diode (D3), the Zener diode (D3) having an anode terminal electrically connected to the drive output terminal (L) and having a cathode terminal connected to the input terminal (A) of the input part (33).

2. The lamp body control apparatus according to Claim 1,
wherein the self-maintaining part (34) shorts the input terminal (A) of the input part (33) and the collector terminal of the bipolar transistor (Tr1).

3. The lamp body control apparatus according to Claim 1 or 2,
wherein the input part (33) includes a further bipolar transistor (Tr3) having a base terminal, which is the input terminal of the input part (33), connected to the cathode of the Zener diode (D3), and having a collector terminal connected to the control part (31) for outputting the status signal thereto.

4. A lamp body lighting system, comprising:
a lamp body control apparatus according to any one of Claims 1 to 3; and the lamp body (15) that blinks based on the blinking signal which is output via the drive output terminal (L) from the lamp body control apparatus.

**Patentansprüche**

1. Eine Lampensteuerungsvorrichtung zur Steuerung, in Übereinstimmung mit einer Betätigung eines Anzeigeschalters (23), der in einem Fahrzeug vorgesehen ist, des Blinkens einer am Fahrzeug vorgesehenen Lampe (15), wobei die Lampensteuerungsvorrichtung umfasst:

eine Antriebs-Ausgangseinheit (L), die elektrisch mit dem Anzeigeschalter (23) verbunden ist und die einen Strom als Blinksignal in die Lampe (15) über den Anzeigeschalter (23) einspeist, der ein Blinken der Lampe (15) veranlasst;
eine Eingangseinheit (33), die über einen Eingangsanschluss (A) verfügt, der über eine Pegelanpassungseinheit (40) mit der Antriebs-Ausgangseinheit (L) verbunden ist, wobei diese Eingangseinheit (33) dazu konfiguriert ist, ein Statussignal auszugeben, das für einen Zustand des Anzeigeschalters (23) repräsentativ ist, wobei dieses Statussignal einen ersten Logikpegel hat, wenn der Eingangsanschluss der Eingangseinheit (33) sich auf einem ersten Spannungspegel befindet, wobei dieser erste Logikpegel dabei repräsentativ für einen ON-Zustand des Anzeigeschalters (23) ist, und wobei dieses Statussignal einen zweiten Logikpegel hat, wenn der Eingangsanschluss der Eingangseinheit (33) sich in einem zweiten Spannungspegel befindet, dieser zweite Logikpegel dabei repräsentativ für einen OFF-Zustand des Anzeigeschalters (23) ist;
eine Steuereinheit (31), die ein Blink-Steuerungssignal ausgibt, wenn das Statussignal, das von der Eingangseinheit (33) ausgegeben wird, den ersten Logikpegel hat;
eine Ausgangseinheit (32), die das Blinksignal erzeugt und das Blinksignal an die Lampe (15) über die Antriebs-Ausgangseinheit (L) ausgibt, wenn das Blink-Steuerungssignal von der Steuereinheit (3) ausgegeben wird;
die Pegelanpassungseinheit (40), die mit der Antriebs-Ausgangseinheit (L) verbunden ist, die ein Signal des zweiten Pegels an das Eingangsanschluss der Eingangseinheit (33) ausgibt, wenn der Anzeigeschalter (23) sich im OFF-Zustand befindet und ein Signal des ersten Pegels an den Eingangsanschluss der Eingangseinheit (33) ausgibt, wenn der Anzeigeschalter (23) in einen ON-Zustand geschaltet wird;
und eine selbst erhaltende Einheit (34), die ein Signal, basierend auf einem Logikpegel des Blink-Steuerungssignals von der Ausgangseinheit (32) an den Eingangsanschluss (31b) liefert, um einen Logikpegel des Statussignals aufrechtzuerhalten, der von der Eingangseinheit (33) erzeugt wird, wenn die Ausgangseinheit (32) den Strom, der die Lampe (15) zum Blinken veranlasst, an die Antriebs-Ausgangseinheit (L) liefert,

**dadurch gekennzeichnet, dass**

die Ausgangseinheit (32) über einen bipolaren Transistor (Tr1) und einen Feldeffekttransistor (Tr2) verfügt, wobei der bipolare Transistor (Tr1) dabei über einen Basisanschluss, der mit der Steuereinheit (31) verbunden ist, und über einen Kollektoranschluss, verbunden mit dem Gate-Anschluss des Feldeffekttransistors (Tr2) verfügt, wobei der Feldeffekttransistor (Tr2) einen Drain-Anschluss, der elektrisch mit der Antriebs-Ausgangseinheit (L) verbunden ist und einen Source-Anschluss, der mit einer Stromquelle (Vcc) verbunden ist, hat; und die Pegelanpassungseinheit (40) über eine Zener-Diode (D3) verfügt, wobei die Zener-Diode (D3) über einen Anodenanschluss, der elektrisch mit dem Antriebs-Ausgangseinheit (L) verbunden ist, und über einen Kathodenanschluss verfügt, der mit dem Eingangsanschluss (A) der Eingangseinheit (33) verbunden ist.

**2.** Lampensteuerungsvorrichtung nach Anspruch 1, wobei die selbst erhaltende Einheit (34) den Eingangsanschluss (A) der Eingangseinheit (33) und den Kollektoranschluss des bipolaren Transistors (Tr1) kurzschließt.

**3.** Lampensteuerungsvorrichtung nach Anspruch 1 oder 2, wobei die Eingangseinheit (33) weiterhin einen bipolaren Transistor (Tr3) mit einem Basisanschluss beinhaltet, bei dem es sich um den Eingangsanschluss der Eingangseinheit (33) handelt, verbunden mit der Kathode (31) der Zener-Diode (D3) sowie mit einem Kollektoranschluss, verbunden mit der Steuereinheit (31), um das Statussignal dorthin auszugeben.

**4.** Ein Lampenbeleuchtungssystem, umfassend:

eine Lampensteuerungsvorrichtung nach der Ansprüche 1 bis 3; und
die Lampe (15), die basierend auf dem Blinksignal blinkt, das über die Antriebs-Ausgangseinheit (L) von der Lampensteuerungsvorrichtung ausgegeben wird.

**Revendications**

**1.** Dispositif de commande de corps de lampe pour commander, conformément à l'actionnement d'un commutateur d'affichage (23) qui est prévu sur un véhicule, le clignotement d'un corps de lampe (15) qui est prévu sur le véhicule, le dispositif de commande de corps de lampe comprenant :

une borne de sortie de commande (L) qui est connectée électriquement au commutateur d'affichage (23) et qui fournit un courant, sous la forme d'un signal de clignotement, au corps de lampe (15) par l'intermédiaire du commutateur d'affichage (23) dans le but d'amener le corps de lampe (15) à clignoter ;
une partie d'entrée (33) qui présente une borne d'entrée (A) qui est connectée par l'intermédiaire d'une partie de réglage de niveau (40) à la borne de sortie de commande (L), ladite partie d'entrée (33) étant configurée de manière à émettre un signal de statut qui est représentatif d'un état du commutateur d'affichage (23), ledit signal de statut présentant un premier niveau logique lorsque la borne d'entrée de la partie d'entrée (33) se trouve à un premier niveau de tension, ledit premier niveau logique étant représentatif d'un état activé (ON) du commutateur d'affichage (23), et ledit signal de statut présentant un second niveau logique lorsque la borne d'entrée de la partie d'entrée (33) se trouve à un second niveau de tension, ledit second niveau logique étant représentatif d'un état désactivé (OFF) du commutateur d'affichage (23) ;
une partie de commander (31) qui délivre le signal de commande de clignotement lorsque le signal de statut qui est émis par la partie d'entrée (33) présente le premier niveau logique ;
une partie de sortie (32) qui génère le signal de clignotement et qui transmet le signal de clignotement au corps de lampe (15) par l'intermédiaire de la borne de sortie de commande (L) lorsque le signal de commande de clignotement est émis par la partie de commande (31) ;
la partie de réglage de niveau (40) qui est connectée à la borne de sortie de commande (L), qui envoie un signal du second niveau à la borne d'entrée de la partie d'entrée (33) lorsque le commutateur d'affichage (23) se trouve dans l'état désactivé (OFF) et qui envoie un signal du premier niveau à la borne d'entrée de la partie d'entrée (33) lorsque le commutateur d'affichage (23) est placé dans un état activé (ON) ; et
une partie de maintien automatique (34) qui transmet un signal basé sur un niveau logique du signal de commande de clignotement depuis la partie extérieure (32) à la borne d'entrée (31b) dans le but de maintenir un niveau logique du signal de statut qui est généré par la partie d'entrée (33) lorsque la partie de sortie (32) fournit à la borne de sortie de commande (L) le courant qui amène le corps de lampe (15) à clignoter,
**caractérisé en ce que** :

la partie de sortie (32) comprend un transistor bipolaire (Tr1) et un transistor à effet de champ (Tr2), le transistor bipolaire (Tr1) présentant une borne de base qui est connectée à la partie de commande (31) et présentant une borne de collecteur qui est connectée à une borne de grille du transistor à effet de champ (Tr2), le transistor à effet de champ (Tr2) présentant une borne de drain qui est connectée électriquement à la borne de sortie de commande (L) et présentant une borne de source qui est connectée à une source électrique (Vcc) ; et

la partie de réglage de niveau (40) comprend une diode Zener (D3), la diode Zener (D3) présentant une borne d'anode qui est connectée électriquement à la borne de sortie de commande (L) et présentant une borne de cathode qui est connectée à la borne d'entrée (A) de la partie d'entrée (33).

2.  Dispositif de commande de corps de lampe selon la revendication 1, dans lequel la partie de maintien automatique (34) court-circuite la borne d'entrée (A) de la partie d'entrée (33) et la borne de collecteur du transistor bipolaire (Tr1).

3.  Dispositif de commande de corps de lampe selon la revendication 1 ou 2, dans lequel la partie d'entrée (33) comprend un transistor bipolaire supplémentaire (Tr3) qui présente une borne de base, qui est la borne d'entrée de la partie d'entrée (33), qui est connectée à la cathode de la diode Zener (D3), et qui présente une borne de collecteur qui est connectée à la partie de commande (31) dans le but de transmettre le signal de statut à celle-là.

4.  Système d'éclairage de corps de lampe, comprenant :

un dispositif de commande de corps de lampe selon l'une quelconque des revendications 1 à 3 ; et

le corps de lampe (15) qui clignote sur la base du signal de clignotement qui est émis par le dispositif de commande de corps de lampe par l'intermédiaire de la borne de sortie de commande (L).

FIG. 1

FIG. 2

FIG. 3

FIG. 4

DRIVE OUTPUT TERMINAL

BLINKING COMMAND SIGNAL
(OUTPUT TERMINAL 31a)

VOLTAGE LEVEL OF POINT A

MAINTAIN LOW BY INPUT OF SWITCH UNIT

TURN ON SWITCH UNIT

BLINKING START

MAINTAIN LOW BY SELF-MAINTAINING PART

EP 3 466 758 B1

FIG. 5

EP 3 466 758 B1

FIG. 6

EP 3 466 758 B1

# FIG. 7

# FIG. 8

**EP 3 466 758 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013199186 A
- JP 2013033610 A